# EUROPEAN PATENT SPECIFICATION

(11) **EP 2 511 921 B1**
(45) Date of publication and mention of the grant of the patent: **22.06.2016**
(21) Application number: 12160452.4
(22) Date of filing: 20.03.2012
(51) Int. Cl.: H01L 49/02, H01G 4/14, H01G 4/18

(54) **Film capacitor element, film capacitor, and method of producing the film capacitor element**
Schichtkondensatorelement, Schichtkondensator und Verfahren zur Herstellung eines Schichtkondensatorelements
Élément de condensateur à film, film condensateur et procédé de production de l'élément de condensateur à film

(30) Priority: 13.04.2011 JP 2011089441
(43) Date of publication of application: 17.10.2012
(73) Proprietor: Kojima Press Industry Co., Ltd., Toyota-shi, Aichi 471-0875 (JP)
(72) Inventor: Terashima, Akito, Toyota-shi, Aichi 471-0875 (JP); Ito, Kaoru, Toyota-shi, Aichi 471-0875 (JP); Hayakawa, Munetaka, Toyota-shi, Aichi 471-0875 (JP)
(74) Representative: Naylor, Matthew John

(56) References cited:
- EP-A1- 0 588 076
- EP-A1- 2 284 850
- JP-A- 3 050 709
- JP-A- 2002 275 619

## Description

### BACKGROUND OF THE INVENTION

### Field of the Invention

The present invention relates to a film capacitor element, a film capacitor, and a method of producing the film capacitor element. More particularly, the present invention relates to a film capacitor element that includes a laminated body including at least one dielectric film and at least one metal deposition film, a method of producing such a film capacitor element, and a film capacitor obtained by using such a film capacitor element.

### Discussion of Related Art

Conventionally, a film capacitor is used in various electric devices. There are two types of film capacitor: a stacked film capacitor and a wound film capacitor. JP-A-10-208972, for example, discloses that the stacked film capacitor is obtained by stacking laminated bodies (metallized films) each including a dielectric film formed of a resin film and a metal deposition film as an electrode film on the dielectric film. JP-A-2008-91605, for example, discloses that the wound film capacitor is obtained by winding the above-described laminated bodies while being stacked with each other.

Electric devices is now increasingly demanded to have a smaller size and higher performance. Along with this demand, a film capacitor is also increasingly demanded to have a smaller size and higher capacity while securing a sufficiently high withstand voltage. However, in the conventional film capacitors, it is difficult to secure sufficient performance to satisfy such demands.

In the conventional film capacitors, generally, a resin film made of polypropylene or polyethylene terephthalate, for example, is used as a dielectric film constituting a laminated body of the film capacitor element. The polypropylene and polyethylene terephthalate have resistance to high voltage, but have a low relative dielectric constant. Thus, in an attempt to increase capacitance of the film capacitor element obtained by stacking or winding the laminated bodies each including the resin film made of polypropylene or polyethylene terephthalate and the metal deposition film on the resin film, the amount of resin film to be used should be increased. That is, in the conventional film capacitor including a polypropylene film or a polyethylene terephthalate film, for example, as the dielectric film, it is difficult to achieve both of a smaller size and higher performance.

Under such a circumstance, JP-A-3-50709 discloses a film capacitor including a ceramic substrate such as alumina or a vapor-deposited polymer film as a dielectric film. The vapor-deposited polymer film is formed on the ceramic substrate by a deposition polymerization of a plurality of fluorinated or fluoroalkylated aromatic monomers. Such a vapor-deposited polymer film has a good quality with fewer impurities and has a sufficiently small thickness. Thus, the vapor-deposited polymer film has a higher withstand voltage and a higher relative dielectric constant than the dielectric film formed of a resin film. Therefore, the technique of forming a vapor-deposited polymer film as a dielectric film in the conventional capacitor may be applied, i.e., a vapor-deposited polymer film may be used as a dielectric film of a film capacitor, to obtain a film capacitor having a smaller size and higher capacity.

However, the study conducted by the present inventors revealed that even if the vapor-deposited polymer film obtained by the deposition polymerization of the plural fluorinated or fluoroalkylated aromatic monomers is used as a dielectric film of the film capacitor, it is difficult to satisfy the recent requirement of higher capacity for a film capacitor. In addition, in some cases, a deposition rate (an amount of deposition per hour) of the vapor-deposited polymer film becomes lower, resulting in the deterioration in productivity.

Other examples of polymer dielectric films are known from EP0588076 and JP2002275619.

### SUMMARY OF THE INVENTION

The present invention has been made in the light of the situations described above, and an object of the invention is to provide a film capacitor element and a film capacitor that have a smaller size and higher capacity while securing the sufficient withstand voltage at a high level and that can efficiently be produced. It is another object of the invention to provide a method of advantageously producing such a film capacitor element.

To achieve the aforementioned objects, the present invention provides a film capacitor element according to claim 1 and a method of producing a film capacitor element according to claim 8. The present inventors have performed a deposition polymerization disclosed in JP-A-3-50709 using a plurality of fluorinated or fluoroalkylated aromatic monomers and examined the cause of the low deposition rate and insufficient capacity in the conventional capacitor including a ceramic substrate and a vapor-deposited polymer film that is formed on the ceramic substrate. As a result, it has been found that the deposition rate of the vapor-deposited polymer film is affected by the molecular weight of the monomer and the relative dielectric constant of the vapor-deposited polymer film that determines the capacitance of the capacitor is largely affected by the molecular structure of the monomer. Based on this fact, the present inventors have conducted further studies and found that a vapor-deposited polymer film having an improved relative dielectric constant can be formed in a high deposition rate by a deposition polymerization of a plurality of monomers having a particular molecular structure that has a small molecular weight.

Therefore, the present invention has been made in the light of the situations described above, and a first aspect of the invention provides a film capacitor element including a laminated body including at least one dielectric film and at least one metal deposition film, wherein at least one of the at least one dielectric film is a vapor-deposited polymer film formed by a deposition polymerization of a plurality of monomers, the plurality of monomers each having a structure in which two benzene rings are linked via a linking group.

Preferably, each of the plurality of monomers has a functional group positioned at a para position with respect to a linking group, and the plurality of monomers are polymerized via the functional group.

Preferably, dipoles in the at least one vapor-deposited polymer film are oriented by being subjected to at least one of a heat treatment, an ultraviolet treatment, an electron-beam treatment, a magnetic treatment, an electric field treatment, and a plasma treatment.

Preferably, the at least one vapor-deposited polymer film is a polyurea resin film.

When the at least one vapor-deposited polymer film is a polyurea resin film, it is preferable that the plurality of monomers include aromatic diamine and aromatic diisocyanate. Preferably, the at least one vapor-deposited polymer film is obtained by polymerizing the aromatic diamine and the aromatic diisocyanate under an aromatic diamine-rich atmosphere in which an aromatic diamine vapor pressure is higher than an aromatic diisocyanate vapor pressure. Further, preferably, the aromatic diamine is 4,4'-diamino diphenyl methane and the aromatic diisocyanate is 4,4'-diphenylmethane diisocyanate.

A second aspect of the present invention provides a film capacitor including the film capacitor element having the above-described structure.

A third aspect of the present invention provides a method of producing a film capacitor element including a laminated body including at least one dielectric film and at least one metal deposition film, including the steps of: (a) obtaining the laminated body such that the at least one metal deposition film and the at least one dielectric film are each positioned alternately; and (b) obtaining a film capacitor element using the laminated body, wherein at least one of the at least one dielectric film is a vapor-deposited polymer film formed by a deposition polymerization of a plurality of monomers, the plurality of monomers each having a structure in which two benzene rings are linked via a linking group.

Preferably, each of the plurality of monomers has a functional group positioned at a para position with respect to a linking group, and the plurality of monomers are polymerized via the functional group.

Preferably, the method further comprises the step of performing at least one of a heat treatment, an ultraviolet treatment, an electron-beam treatment, a magnetic treatment, an electric field treatment, and a plasma treatment to the at least one vapor-deposited polymer film.

Preferably, the plurality of monomers include aromatic diamine and aromatic diisocyanate, and the at least one vapor-deposited polymer film formed of a polyurea resin film is formed by the deposition polymerization of the aromatic diamine and the aromatic diisocyanate.

When the aromatic diamine and the aromatic diisocyanate are used as the plurality of monomers, preferably, the at least one vapor-deposited polymer film is formed by polymerizing the aromatic diamine and the aromatic diisocyanate under an aromatic diamine-rich atmosphere in which an aromatic diamine vapor pressure is higher than an aromatic diisocyanate vapor pressure. Further, preferably, the aromatic diamine is 4,4'-diamino diphenyl methane and the aromatic diisocyanate is 4,4'-diphenylmethane diisocyanate.

In the film capacitor according to the present invention, at least one of at least one dielectric film is a vapor-deposited polymer film. The vapor-deposited polymer film is formed by the deposition polymerization in a vacuum. Thus, the vapor-deposited polymer film can have excellent quality having few impurities and can have a sufficiently small thickness. Accordingly, the withstand voltage and the relative dielectric constant of the dielectric film including such a vapor-deposited polymer film can be higher than those of the dielectric film including only a resin film.

In addition, the vapor-deposited polymer film is formed by the deposition polymerization of the aromatic monomers each having two benzene rings linked by a linking group. Thus, the relative dielectric constant of the vapor-deposited polymer film is further effectively improved. Further, since the molecular weight of the aromatic monomer is advantageously reduced, the deposition rate of the vapor-deposited polymer film is advantageously improved.

As a result, the film capacitor element according to the present invention can have a smaller size and higher capacity while securing a sufficiently high withstand voltage. In addition, the productivity can be effectively improved by the improvement of the deposition rate of the vapor-deposited polymer film.

The film capacitor according to the present invention can have substantially the same advantages obtained in the film capacitor element.

According to a method of producing a film capacitor element of the present invention, the film capacitor element having the above-described excellent characteristic can be advantageously produced with excellent productivity.

### BRIEF DESCRIPTION OF THE DRAWINGS

The above and other objects, features, advantages and technical and industrial significance of the present invention will be better understood by reading the following detailed description of a preferred embodiment of the invention, when considered in connection with the accompanying drawings, in which:
Fig. 1 is a partially enlarged cross sectional view showing one example of a film capacitor element according to the present invention; and
Fig. 2 is a view schematically showing an apparatus for producing a film capacitor shown in Fig. 1.

### DETAILED DESCRIPTION OF THE INVENTION

To further clarify the present invention, there will be described in detail embodiments of the present invention with reference to the accompanying drawings.

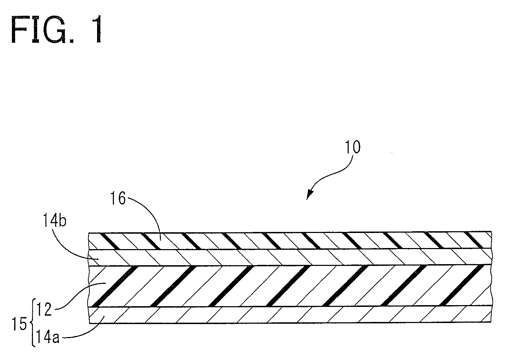

Initially, Fig. 1 shows one embodiment of the film capacitor element according to the present invention in a vertical cross section. As shown in Fig. 1, a film capacitor element 10 of the present embodiment includes a metallized film 15 including a metal deposition film 14a and a resin film 12 as a dielectric film on a surface of the metal deposition film 14a. The film capacitor element 10 further includes a metal deposition film 14b on the metallized film 15 at the side opposite to the metal deposition film 14a side (the other surface of the resin film 12) and a vapor-deposited polymer film 16 on the metal deposition film 14b. That is, in the present embodiment, the film capacitor element 10 is a laminated body including, in sequence, the metal deposition film 14a, the resin film 12, the metal deposition film 14b, and the vapor-deposited polymer film 16.

More specifically, the resin film 12 is formed of a biaxially stretched film made of polypropylene and has a small thickness of about 1 to 10 µm. The resin film 12 may be any known resin film that can constitute a dielectric film of the conventional film capacitor. The resin film may be made of polyethylene terephthalate, polyphenylene sulfide, or polyethylene naphtalate, for example. The resin film is not necessary formed of a biaxially stretched film.

Here, the metal deposition films 14a, 14b are made of aluminum. The respective metal deposition films 14a, 14b constitutes an internal electrode of the film capacitor produced using the laminated body 10 and is formed on the respective surfaces of the resin film 12 by a conventional process. Specifically, the metal deposition films 14a, 14b are formed on the respective surfaces of the resin film 12 by a conventionally known vacuum deposition process that is in the same category as PVD and CVD by using a conventionally known metal material as a deposition material that forms the internal electrode of the film capacitor. Thus, the metal deposition films 14a, 14b are not necessarily made of aluminum, but may be made of zinc, for example. Membrane resistance of the metal deposition films 14a, 14b is adjusted to about 1 to 50 Ω/cm² and the thickness thereof is suitably determined depending on the membrane resistance, for example.

The vapor-deposited polymer film 16 is formed of a polyurea resin film. The vapor-deposited polymer film 16 is formed on the metal deposition film 14a by a conventional vacuum deposition polymerization. Thus, the vapor-deposited polymer film 16 can have a high quality with few impurities and a thickness that is sufficiently smaller than the resin film. As a result, the film capacitor including the film capacitor element 10 can have a smaller size and higher capacity.

Although the thickness of the vapor-deposited polymer film 16 is not particularly limited, it is preferable that the thickness thereof be about 0.001 to 10 µm. Since it is difficult to form the vapor-deposited polymer film 16 having a thickness of less than 0.001 µm, it is practical that the thickness of the vapor-deposited polymer film 16 is 0.001 µm or more. Further, the vapor-deposited polymer film 16 having a thickness of more than 10 µm cannot sufficiently downsize the film capacitor including the vapor-deposited polymer film 16 as the dielectric.

A kind of the vapor-deposited polymer film 16 is not particularly limited as long as it is a resin film that can be formed by a vacuum deposition. Instead of a polyurea resin film, the vapor-deposited polymer film 16 may be formed of a polyamide resin film, a polyimide resin film, a polyamideimide resin film, a polyester resin film, a polyazomethine resin film, or a polyurethane resin film. Among the above listed resin films, one having a higher relative dielectric constant than the resin film 12 is favorably used. The capacitance of the film capacitor can be effectively increased by the formation of the vapor-deposited polymer film 16 using such a resin film.

The polyurea resin constituting the vapor-deposited polymer film secures the higher relative dielectric constant than the resin film 12 and requires no heat treatment in the polymerization of monomers (diisocyanate and diamine). Further, the polyurea resin is formed in the addition polymerization reaction which is free from elimination of water, alcohol and the like. Consequently, equipments (facilities) for heat treatment in the polymerization of monomers is not necessary and a cost can be reduced. Further, deformation of the resin film 12 by the heat generated during the heat treatment can be effectively avoided. Furthermore, there is no need to remove water, alcohol, and the like, which are eliminated during the polymerization reaction, from the vacuum chamber in which the polymerization reaction proceeds. Therefore, equipments for removing the eliminated water or alcohol are not necessary, which also resulting in the reduction of the cost. In addition, since the polyurea resin has excellent moisture resistance, the high withstand voltage of the vapor-deposited polymer film 16 can be stably secured.

In the present embodiment, particularly, among the polyurea resin, the vapor-deposited polymer film 16 is formed of an aromatic polyurea resin. The vapor-deposited polymer film 16 formed of the aromatic polyurea resin film is formed by deposition polymerization of aromatic diisocyanate and aromatic diamine each having a structure in which two benzene rings are linked via a linking group.

Further, in the present embodiment, 4,4'-diphenylmethane diisocyanate (MDI) represented by the following formula (chemical formula 1) is used as the aromatic diisocyanate, and 4,4'-diamino diphenyl methane (MDA) represented by the following formula (chemical formula 2) is used as the aromatic diamine. Since the vapor-deposited polymer film 16 is formed by the deposition polymerization of the aromatic diisocyanate and the aromatic diamine, the relative dielectric constant and the deposition rate of the vapor-deposited polymer film 16 are improved.

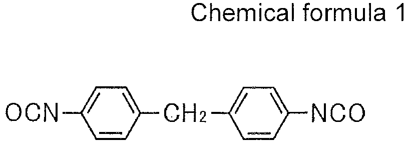

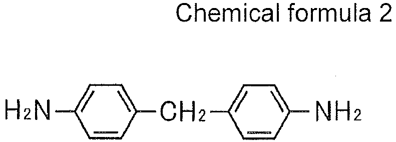

More specifically described, the aromatic monomer having a benzene ring has a planar molecular structure so that the structure thereof is more stable than the monomer having a straight-chain structure or an alicyclic structure. The vapor-deposited polymer film 16 formed by the deposition polymerization of such aromatic monomers, i.e., MDI and MDA, is laminated densely in a plane on the metal deposition film 14b on the resin film 12. Thus, a density of the vapor-deposited polymer film 16 is increased, leading to the improvement of the relative dielectric constant of the vapor-deposited polymer film 16.

Since each of MDI and MDA, which form the vapor-deposited polymer film 16, has two benzene rings, a molecular weight of each of MDI and MDA is smaller than that of each of the aromatic diisocyanate and the aromatic diamine that has three or more benzene rings. Thus, in the formation of the vapor-deposited polymer film 16 by the deposition polymerization of MDI and MDA, since the molecular weight thereof is smaller, the evaporation rate of each of MDI and MDA is effectively improved compared to the case where the aromatic diisocyanate and the aromatic diamine each having three or more benzene rings are used. As a result, the deposition rate of the vapor-deposited polymer film 16 is improved.

Generally, a molecular structure of each of the diisocyanate and the diamine having a straight-chain structure or an alicyclic structure is unstable, compared to that of the aromatic diisocyanate and the aromatic diamine. Particularly, each of the diisocyanate and the diamine having an alicyclic structure has a bent structure and undergo a larger steric hindrance. Thus, if the vapor-deposited polymer film 16 is formed by the deposition polymerization using the diisocyanate having an alicyclic structure or the diamine having an alicyclic structure, the density of the vapor-deposited polymer film 16 is inevitably made small, and the relative dielectric constant should not be further improved. Further, aromatic diisocyanate or aromatic diamine that has only one benzene ring or two benzene rings directly linked without a linking group has a limitation that an atomic group in a molecule can only be moved around a functional group that polymerizes the diisocyanate and the diamine. Thus, it may be difficult to straighten the molecular structure.

On the other hand, MDI that is the aromatic diisocyanate and MDA that is the aromatic diamine, each having two benzene rings linked via a linking group, have a stable molecular structure. Further, since the atomic group is allowed to be moved around a functional group and a linking group in a molecule, the molecular structure can be substantially straightened. The vapor-deposited polymer film 16 formed by the deposition polymerization of MDI and MDA can be formed on the metal deposition film 14b on the resin film 12 such that it is closely laminated thereon. As a result, the relative dielectric constant of the vapor-deposited polymer film 16 is improved.

Further, as apparent from the above chemical formulas 1 and 2, MDI that is the aromatic diisocyanate and MDA that is the aromatic diamine, which form the vapor-deposited polymer film 16, have an isocyanate group (-NCO) and an amino group (-NH₂), respectively, as a functional group at a para position with respect to a linking group [methyl group (-CH₂-)]. In other words, MDI and MDA each have a functional group that is positioned at a para position with respect to a linking group and MDI and MDA are polymerized via these functional groups. Thus, molecular structures of MDI and MDA can be substantially in a straight line. As a result, the relative dielectric constant of the vapor-deposited polymer film 16 is further improved.

The aromatic diisocyanate and the aromatic diamine used in the formation of the vapor-deposited polymer film 16 formed of the aromatic polyurea resin film are not particularly limited to MDI and DMA. Any aromatic diisocyanate and aromatic diamine in which two benzene rings are linked via a linking group may be used. Examples of the aromatic diamine include bis(4-aminophenyl)sulfide, 4,4'-diaminodiphenylether, and 4,4'-diaminophenylsulfone.

Among the above aromatic diisocyanate and aromatic diamine, it is preferable that one having a methyl group (-CH₂-), an ether group (-O-), or a thioether group (-S-) as a linking group be used. Especially, one having a methyl group (-CH₂-) as a linking group is preferably used. By the use of such an aromatic diisocyanate and aromatic diamine, the vapor-deposited polymer film 16 made of the deposited aromatic polyurea can have the improved relative dielectric constant and the deposition rate of the vapor-deposited polymer film 16 can be increased.

In the production of a wound film capacitor using the film capacitor element 10 having the above-described structure, first, the film capacitor element 10 is wound once or a plurality of times such that the vapor-deposited polymer film 16 is positioned inner most, thereby obtaining a roll. A predetermined core may be used in this process. Second, an external electrode is formed on each side face of the obtained roll and an external terminal is attached to the external electrode. Then, as necessary, the laminated body is sealed in a predetermined case, thereby obtaining an intended wound film capacitor.

A film capacitor may be obtained using a plurality of film capacitor elements 10. In such a case, the laminated body that is a basic element of the film capacitor is constituted by a plurality of film capacitor elements 10, and first, the film capacitor elements 10 are stacked such that the metal deposition film 14a of one of the film capacitor elements 10 and the vapor-deposited polymer film 16 of another one of the film capacitor elements 10 are contacted with each other. Second, the obtained laminated body is wound once or plurality of times to obtain a roll. Then, an external electrode is formed on each side face of the obtained roll (wound film capacitor element) and an external terminal is attached to the external electrode. Then, as necessary, the laminated body is sealed in a predetermined case, thereby obtaining an intended wound film capacitor.

A stacked film capacitor may be produced using the film capacitor element 10. Also in such a case, the laminated body that is a basic element of the film capacitor is constituted by a plurality of film capacitor elements 10, and first, the film capacitor elements 10 are stacked to obtain a laminated body such that the metal deposition film 14a of one of the film capacitor elements 10 and the vapor-deposited polymer film 16 of another one of the film capacitor elements 10 are contacted with each other. Second, an external electrode is formed on each side face of the laminated body and an external terminal is attached to the external electrode. Then, as necessary, the laminated body is sealed in a predetermined case, thereby obtaining an intended stacked film capacitor.

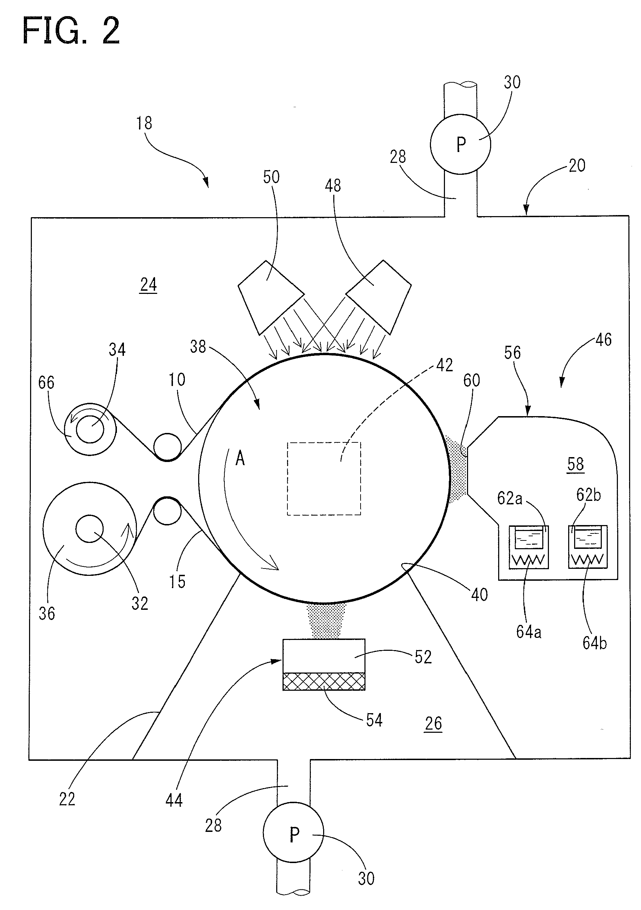

The above-described film capacitor element 10 is produced by a production apparatus 18 shown in Fig. 2, for example. Hereinafter, the production apparatus 18 of the film capacitor element 10 will be described in detail.

As shown in Fig. 2, the production apparatus 18 includes a vacuum chamber 20 having a predetermined size. In the vacuum chamber 20, partition walls 22 are provided such that an inner space of the vacuum chamber 20 is divided into two. The partition walls 22 define a first vacuum section 24 and a second vacuum section 26 in the vacuum chamber 20.

To the first vacuum section 24 and the second vacuum section 26, exhaust pipes 28, 28 are each connected such that the inner spaces of the respective vacuum sections 24, 26 are communicated with the outside. On the exhaust pipes 28, 28, vacuum pumps 30, 30 are each provided. By the operation of the vacuum pumps 30, 30, each of the first vacuum section 24 and the second vacuum section 26 is made to be in a vacuum state. Further, the operation of the vacuum pumps 30, 30 can be controlled separately. Thus, the vacuum degree of the first vacuum section 24 and the second vacuum section 26 can be varied.

In the first vacuum section 24 of the vacuum chamber 20, a feeding roller 32 and a take up roller 34 are provided. On the feeding roller 32, a film roll 36 that is obtained by winding the metallized film 15 in which the metal deposition film 14a is formed on one surface of the resin film 12 is fitted. On the take up roller 34, a tip end portion of the metallized film 15 that is unwound from the film roll 36 fitted on the feeding roller 32 is wound in a removable manner. The take up roller 34 is rotationally driven by an electric motor (not shown), for example. By this arrangement, the metallized film 15 that is unwound from the film roll 36 is taken up by the take up roller 34 with the rotational drive of the take up roller 34.

In the first vacuum section 24, a can roller 38 is provided. The can roller 38 is formed of a cylindrical body made of metal such as iron and is rotationally driven by an electric motor (not shown), for example. A part of the can roller 38 is exposed into the second vacuum section 26 through the window 40 provided by the partition walls 22.

The metallized film 15 unwound from the film roll 36 is wound on the outer peripheral surface of the can roller 38 in close contact therewith, and then wound on the take up roller 34. Accordingly, the metallized film 15 unwound from the film roll 36 is traveled in one direction of the circumferential direction of the can roller 38 (in a direction A indicated by an arrow in Fig. 2) with the rotational drive of the can roller 38 while a surface of the resin film 12 that is positioned at the side opposite to the metal deposition film 14a is exposed to the vacuum chamber 20. Then, the metallized film 15 is sent to and taken up by the take up roller 34.

In the inside of the can roller 38, a cooling mechanism 42 is provided. The cooling mechanism 42 has a known structure in which the outer peripheral surface of the can roller 35 is cooled by a circulation of a cooling medium, for example. The metallized film 15 wound on the can roller 38 is cooled through the contact with the outer peripheral surface of the can roller 38 that is cooled by the cooling mechanism 42.

Around the can roller 38 in the vacuum chamber 20, a device for forming a metal deposition film 44, a device for forming a vapor-deposited polymer film 46, an infrared irradiation device 48, and a plasma irradiation device 50 are arranged so as to be in line in a circumferential direction of the can roller 38. These four devices 44, 46, 48, 50 are arranged in the order of the description from the upper stream side to the lower stream side in the traveling direction of the metallized film 15 that travels with the rotation of the can roller 38. Of the four devices 44, 46, 48, 50, the device for forming a metal deposition film 44 only is positioned in the second vacuum section 26, and the other devices 46, 48, 50 are positioned in the first vacuum section 24.

The device for forming a metal deposition film 44 includes a heater 54 and a storage tank 52 for storing a deposition material (not shown) including metal such as aluminum. The device for forming a metal deposition film 44 is configured to generate a metal vapor by evaporating the deposition material in the storage tank 52 using the heater 54, and deposit the metal vapor on the metallized film 15 wound on the can roller 38. As a result, the metal deposition film 14b is formed on the resin film 12 at the side opposite to the metal deposition film 14a side.

The device for forming a vapor-deposited polymer film 46 includes a casing 56. The inside of the casing 56 is made as a mixing chamber 58. The casing 56 includes an outlet 60 that opens to the outer peripheral surface of the can roller 38, whereby the mixing chamber 58 is communicated with the first vacuum section through the outlet 60. Further, in the casing 56, there are provided first and second monomer pots 62a, 62b for containing monomer in a liquid form, and first and second heaters 64a, 64b.

The device for forming a vapor-deposited polymer film 46 is configured to generate two kinds of monomer vapor by evaporating two kinds of monomer each contained in the first and second monomer pots 62a, 62b using the first and second heaters 64a, 64b. After the two kinds of monomer vapor are mixed in the mixing chamber 58, the mixed two kinds of monomer vapor are blown off from the outlet 60 onto the metallized film 15 wound on the can roller 38. Thus, the two kinds of monomer vapor are deposited on the resin film 12 of the metallized film 15 at the side opposite to the metal deposition film 14a and polymerized thereon to form the vapor-deposited polymer film 16.

The infrared irradiation device 48 has a conventionally known structure for generating infrared rays and can emit the generated infrared rays on the outer peripheral surface of the can roller 38. Therefore, the metallized film 15 that travels while being wound on the can roller 38 can be subjected to a heat treatment by the infrared irradiation.

The plasma irradiation device 50 has a conventionally known structure for generating plasma (for example, plasma of argon gas) and can emit the generated plasma on the outer peripheral surface of the can roller 38. Therefore, the metallized film 15 that travels while being wound on the can roller 38 can be subjected to a plasma treatment by the plasma irradiation.

Here, the plasma emitted from the plasma irradiation device 50 and the infrared rays emitted from the infrared irradiation device 48 are targeted at the same position of the outer peripheral surface of the can roller 38. Thus, the heat treatment and the plasma treatment are performed at the same time on a part of the metallized film 15 wound on the can roller 38.

In the production of the film capacitor element 10 with the production apparatus 18 having the above-described structure, as shown in Fig. 2, initially, the film roll 36 is externally fitted on the feeding roller 32. Then, an end portion of the metallized film 15 is attached to the feeding roller 34 after the metallized film 15 is unwound from the film roll 36 and wound on the can roller 38.

Concurrently with, or before or after the operation to wind the metallized film 15 onto the can roller 38, the cooling mechanism 42 built in the can roller 38 is activated to cool the outer peripheral surface of the can roller 38. Thus, the metallized film 15 wound on the can roller 38 is cooled. The cooling temperature of the metallized film 15 with the cooling mechanism 42 is not particularly limited. Generally, the temperature is about -15 to 30°C, because the vapor deposition polymerization process that will be described below can be stably performed.

Separately from the operation to wind the metallized film 15 on the can roller 38, the aluminum deposition material is contained in the storage tank 52 of the device for forming a metal deposition film 44. Further, a predetermined amount of the aromatic diisocyanate having a particular molecular structure (MDI, for example) is contained in a liquid state in the first monomer pot 62a of the device for forming a vapor-deposited polymer film 46. In addition, a predetermined amount of the aromatic diamine having a particular molecular structure (MDA, for example) is contained in a liquid state in the second monomer pot 62b.

Then, the vacuum pumps 30, 30 are activated to reduce the pressure in the first and second vacuum sections 24, 26 of the vacuum chamber 20 such that they are in a vacuum state. As a result, the pressure in the first vacuum section 24 is adjusted to about 10⁻¹ to 100 Pa and the pressure in the second vacuum section 26 is adjusted to about 10⁻² to 5 Pa, which is lower than the first vacuum section 24. Further, the heater 54 of the device for forming a metal deposition film 44 and the first and second heaters 64a, 64b of the device for forming a vapor-deposited polymer film 46 are activated to respectively heat and evaporate the aluminum deposition material in the storage tank 52 and the aromatic diisocyanate and the aromatic diamine in the first and second monomer pots 62a, 62b.

Then, an electric motor is rotationally driven to rotate the can roller 35 in the direction indicated by the arrow A in Fig. 2. At the same time, the take up roller 34 is rotationally driven. Thus, the metallized film 15 unwound from the film roll 36 is traveled in the direction indicated by the arrow A in Fig. 2 and the metallized film 15 sent from the can roller 38 is taken up by the take up roller 34.

A part of the metallized film 15 wound on the can roller 38 is entered into the second vacuum section 26 by the rotation of the can roller 38. Therein, the aluminum vapor generated by the device for forming a metal deposition film 44 is sprayed on the surface of the metallized film 15 at the side opposite to the can roller 38 side (the surface exposed to the vacuum chamber 20). As a result, the metal deposition film 14b is formed on the metallized film 15 at the side opposite to the metal deposition film 14a.

During the above operation, since the inner pressure of the second vacuum section 26 is lower than that of the first vacuum section 24, it is advantageously prevented that the aluminum vapor generated by the device for forming a metal deposition film 44 enters into the first vacuum section 24 from the second vacuum section 26. Further, since the metallized film 15 is cooled through the contact with the outer peripheral surface of the can roller 38 that is cooled by the cooling mechanism 42, it can be advantageously prevented that the aluminum vapor having a high temperature is contacted with or adhered to the resin film and the resin film is damaged from the heat.

The part of the metallized film 15 on which the metal deposition film 14b is deposited is entered into the first vacuum section 24 from the second vacuum section 26 by the rotation of the can roller 38, thereby being positioned in the area where the device for forming a vapor-deposited polymer film 46 is provided. Then, the aromatic diisocyanate vapor and the aromatic diamine vapor that are mixed in the mixing chamber 58 of the casing 56 of the device for forming a vapor-deposited polymer film 46 are deposited on the metal deposition film 14b formed on the metallized film 15 to undergo self polymerization. As a result, the vapor-deposited polymer film 16 formed of an aromatic polyurea resin film is formed on the metal deposition film 14b. The intended film capacitor element 10 is thus obtained.

Preferably, the formation of the vapor-deposited polymer film 16 is conducted while the inside of the mixing chamber 58 of the device for forming a vapor-deposited polymer film 46 is in an aromatic diamine-rich atmosphere in which an aromatic diamine vapor pressure is higher than an aromatic diisocyanate vapor pressure. In other words, the deposition polymerization is conducted under an aromatic diamine-rich atmosphere. Therefore, the relative dielectric constant of the vapor-deposited polymer film 16 is advantageously improved. This may be based on the following reasons.

Under the aromatic diamine-rich atmosphere, the number of molecules of the aromatic diamine is larger than that of the aromatic diisocyanate. The aromatic polyurea formed by the deposition polymerization of the aromatic diamine and the aromatic diisocyanate under such a state has a shorter molecular chain (oligomeric state) than the aromatic polyurea formed by the deposition polymerization under the atmosphere in which the composition ratio of the aromatic diamine and the aromatic diisocyanate is 1:1. Molecules in the aromatic polyurea film having a short molecular chain can move in the film more freely than molecules in the aromatic polyurea film having a long molecular chain, resulting in more active movement of the molecules. As a result, the relative dielectric constant of the vapor-deposited polymer film 16 formed by the deposition polymerization of the aromatic diamine and the aromatic diisocyanate can be higher.

Under the aromatic diamine-rich atmosphere, the number of molecules of the aromatic diisocyanate is larger than that of the aromatic diamine. Under such a state, the isocyanate group is easily reacted with moisture in the air. Thus, in the case where the monomer pot containing the aromatic diisocyanate is provided at the outside of the vacuum chamber 20, the relative dielectric constant of the vapor-deposited polymer film 16 formed by the deposition polymerization of the aromatic diamine and the aromatic diisocyanate under the aromatic diisocyanate-rich atmosphere is not so improved compared with that of the vapor-deposited polymer film 16 formed by the deposition polymerization of the aromatic diamine and the aromatic diisocyanate under the aromatic diamine-rich atmosphere.

The aromatic diamine-rich atmosphere is easily provided, for example, by adjusting the heat temperature of the aromatic diamine in the second monomer pot 62b with the second heater 64b of the device for forming a vapor-deposited polymer film 46 to be higher than that of the aromatic diisocyanate in the first monomer pot 62a with the first heater 64a. Although the composition ratio of the aromatic diamine and the aromatic diisocyanate in the aromatic diamine-rich atmosphere is not particularly limited, it is preferable that the amount of the aromatic diamine is more than the amount of the aromatic diisocyanate, but less than four times the amount of the aromatic diisocyanate. In the atmosphere in which the amount of the aromatic diamine is four times the amount of the aromatic diisocyanate, the amount of the diamine is too much and the aromatic diamine and the aromatic diisocyanate are not sufficiently polymerized. This may cause difficulties in the formation of the vapor-deposited polymer film 16 made of the aromatic polyurea resin.

Then, the part of the metallized film 15 on which the metal deposition film 14b and the vapor-deposited polymer film 16 are deposited is traveled by the rotation of the can roller 38 to the position where the infrared irradiation device 48 emits infrared rays and the plasma irradiation device 50 emits plasma. Then, the infrared rays and the plasma are emitted from the infrared irradiation device 48 and the plasma irradiation device 50 to the vapor-deposited polymer film 16 at the same time. Accordingly, the heat treatment and the plasma treatment are performed on the vapor-deposited polymer film 16 at the same time. For example, the heat treatment with the infrared irradiation is performed at 160°C for 10 minutes.

The relative dielectric constant of the vapor-deposited polymer film 16 is improved by such heat treatment and plasma treatment. This may be based on that dipoles in the vapor-deposited polymer film 16 are oriented in the same direction (polarization) by the heat treatment and the plasma treatment, so that polarizability in the vapor-deposited polymer film 16 is increased.

Post-treatments by the heat treatment and the plasma treatment to the vapor-deposited polymer film 16 are performed in order to assist the orientation of the dipoles in the vapor-deposited polymer film 16. Accordingly, the post treatment to the vapor-deposited polymer film 16 may be any treatment other than the heat treatment and the plasma treatment that are concurrently performed as long as the same result is obtained. For example, one of the heat treatment and the plasma treatment may be initially performed, and then the other one of them may be performed to the vapor-deposited polymer film 16. Further, instead of the heat treatment and the plasma treatment, one of an ultraviolet treatment, an electron-beam treatment, a magnetic treatment, and an electric field treatment may be performed. Further, at least two of the heat treatment, the plasma treatment, the ultraviolet treatment, the electron-beam treatment, the magnetic treatment, and the electric field treatment may be performed concurrently or separately.

When the ultraviolet treatment and the electron-beam treatment are performed, an ultraviolet irradiation device and an electron-beam irradiation device are provided around the can roller 38. The ultraviolet treatment and the electron-beam treatment are performed by applying the ultraviolet rays and the electron beams onto the vapor-deposited polymer film 16 using the devices. When the magnetic treatment is performed, for example, the obtained film capacitor element 10 is positioned in a magnetic field generated by a coil or the like for a predetermined time. When the electric field treatment is performed, for example, the film capacitor element 10 is positioned in an electric filed atmosphere for a predetermined time by applying a predetermined voltage to the two electrodes that are positioned so as to have the obtained film capacitor element 10 therebetween.

After completion of the post-treatment to the vapor-deposited polymer film 16, the obtained film capacitor element 10 is sent from the can roller 38 by the rotation of the can roller 38 to the take up roller 34. As a result, a film roll 66 constituted by a roll of the film capacitor element 10 is obtained.

As described above, in the film capacitor element 10 of the present embodiment, in addition to the resin film 12, the vapor-deposited polymer film 16 having a small thickness is formed as the dielectric film. The vapor-deposited polymer film 16 is formed by the deposition polymerization of the aromatic diisocyanate and the aromatic diamine each having a structure in which two benzene rings are linked via a linking group. Thus, in the vapor-deposited polymer film 16, the relative dielectric constant is advantageously improved and the deposition rate is increased while securing the sufficient voltage.

As a result, the film capacitor element 10 according to the present embodiment has a smaller size and higher capacity while securing a sufficiently high withstand voltage at a high level. In addition, the productivity can be effectively improved by the improvement of the deposition rate of the vapor-deposited polymer film 16.

Further, in the film capacitor element 10, MDI that is the aromatic diisocyanate and MDA that is the aromatic diamine each having a functional group that is positioned at a para position with respect to a linking group are polymerized under the aromatic diamine-rich atmosphere to form the vapor-deposited polymer film 16. Further, the vapor-deposited polymer film 16 is subjected to the heat treatment and the plasma treatment to orient the dipoles in the vapor-deposited polymer film 16 in the same direction. As a result, the relative dielectric constant of the vapor-deposited polymer film 16 is sufficiently improved. Thus, in the film capacitor element 10, the capacitance is further effectively improved.

Hereinafter, experiments conducted by the inventors will be described in detail to confirm that the film capacitor element according to the present invention has the above-described excellent characteristics.

First, the following experiment was conducted to confirm that the vapor-deposited polymer film formed by the deposition polymerization of the aromatic diisocyanate and the aromatic diamine each having the structure according to the present invention has a high relative dielectric constant and a high deposition rate.

Initially, a predetermined amount of MDI was provided as aromatic diisocyanate having a structure in which two benzene rings are linked via a linking group. Further, a predetermined amount of each of MDA, bis(aminophenyl)sulfide, and 4,4'-diaminodiphenylether was provided as the aromatic diamine having a structure in which two benzene rings are linked via a linking group. Further, there were provided a commercially available metallized film including a polypropylene film and an aluminum vapor-deposited film on a surface of the polypropylene film, and an apparatus for producing a vapor-deposited polymer film that has a conventional structure.

After the metallized film was set in the apparatus for producing a vapor-deposited polymer film, the inside of the vacuum chamber was made to be in a vacuum state. Then, MDI vapor and MDA vapor were introduced into the vacuum chamber and polymerized on the aluminum vapor-deposited film of the metallized film, thereby forming a vapor-deposited polymer film formed of an aromatic polyurea film on the aluminum vapor-deposited film, and a laminated film was obtained. This laminated film is referred to as Specimen 1.

By the same process as the formation process of the laminated film of Specimen 1 expect that MDI and bis(4-aminophenyl)sulfide were used as the monomers, there was produced another laminated film including a vapor-deposited polymer film formed of an aromatic polyurea resin film of a different kind from the vapor-deposited polymer film of the laminated film of Specimen 1. This laminated film is referred to as Specimen 2.

By the same process as the formation process of the laminated film of Specimen 1 expect that MDI and 4,4'-diaminodiphenylether were used as the monomers, there was produced further another laminated film including a vapor-deposited polymer film formed of an aromatic polyurea resin film of a further different kind from the vapor-deposited polymer film of the laminated film of Specimen 1. This laminated film is referred to as Specimen 3.

The relative dielectric constant of the vapor-deposited polymer film formed in each of the laminated film of Specimens 1 to 3 was measured by a conventional method. The results thereof are shown in the following table 1. The vapor-deposited polymer film in each of Specimens 1 to 3 of the laminated films was formed under a discharge pressure of 1 Pa, a deposition time of 5 minutes, and each of an aromatic diamine vapor pressure and an aromatic diisocyanate vapor pressure of 2 Pa.

Then, combinations of diamine and diisocyanate were prepared as shown in Table 1. A combination α includes diamine and diisocyanate that are aromatic, but one of them does not have a structure in which two benzene rings are linked via a linking group, and a combination β includes diamine and diisocyanate in which at least one of them is not aromatic.

The combination α includes the following combinations: (a) a combination of diamine having a structure in which two benzene rings are directly linked and diisocyanate having a structure in which two benzene rings are linked via a linking group (Specimen 4 which will be described later); (b) a combination of diamine having a structure in which three benzene rings are linked via a linking group and diisocyanate having a structure in which two benzene rings are linked via a linking group (Specimen 5 which will be described later); and (c) a combination of diamine having a structure in which four benzene rings are linked via a linking group and diisocyanate having a structure in which two benzene rings are linked via a linking group (Specimen 6 which will be described later).

The combination β includes the following combinations: (a) a combination of diamine having a straight-chain structure and diisocyanate having an alicyclic structure (Specimens 7 and 8 which will be described later); (b) a combination of diamine having an alicyclic structure and diisocyanate having an alicyclic structure (Specimen 9 which will be described later); (c) a combination of diamine having an alicyclic structure and aromatic diisocyanate (Specimens 10, 11, 13, 14 which will be described later); and (d) a combination of diamine having a straight-chain structure and aromatic diisocyanate (Specimen 12 which will be described later).

On a surface of each of eleven metallized films, a vapor-deposited polymer film formed of a polyurea resin film having various molecular structures was formed using the diamine and diisocyanate in the above-described combinations to obtain eleven laminated films. The eleven laminated films are referred to as Specimens 4 to 14.

The vapor-deposited polymer films of Specimens 4 to 14 were formed under the same conditions as the vapor-deposited polymer film of Specimen 1. As shown in the following Table 1, the following diamine and diisocyanate were used in Specimens: 1,5-diaminonaphtalene was used as the diamine having a structure in which two benzene rings are directly linked; 1,3-bis(4-aminophenoxy)benzene was used as the diamine having a structure in which three benzene rings are linked via a linking group; bis[4-(4-aminophenoxy)phenyl] sulfone was used as the diamine having a structure in which four benzene rings are linked via a linking group; and 1,8-diaminooctane, N,N'-dimethyl-1, 6-diaminohexane, and 1,12-diaminododecane were used as the diamine having a straight-chain structure; 1,3-bis(aminomethyl)cycloxane (cis-, trans-mixture) and 4,4'-methylenbis(cyclohexylamine) (isomeric mixture) were used as the diamine having an alicyclic structure; and MDA was used as the aromatic diamine. As the diisocyanate having an alicyclic structure, 1,3-bis(isocyanatomethyl)cyclohexane was used. Other than MDI, m-xylylene diisocyanate and 1,4-phenylendiisocyanate were used as the aromatic diisocyanate.

Of the laminated films of Specimens 1 to 14, the deposition rate of the vapor-deposited polymer film of each of the laminated films of Specimens 1 to 6 was examined during the production thereof. Separately from this, after the production of the laminated films of Specimens 1 to 14, the relative dielectric constant of the vapor-deposited polymer film formed in each of the laminated films was measured using a conventionally known method. The results thereof are also shown in Table 1 below.

**Table 1**

| | Monomer | | Relative Dielectric Constant | Deposition Rate (µm/min) |
|---|---|---|---|---|
| | Diamine | Diisocyanate | | |
| Specimen 1 | MDA | MDI | 5.08 | 0.500 |
| Specimen 2 | bis(4-aminophenyl)sulfide | MDI | 4.97 | 0.214 |
| Specimen 3 | 4,4'-diaminodiphenylether | MDI | 4.68 | 0.494 |
| Specimen 4 | 1,5-diaminonaphtalene | MDI | 4.27 | 0.330 |
| Specimen 5 | 1,3-bis(4-aminophenoxy) benzene | MDI | 4.52 | 0.035 |
| Specimen 6 | bis [(4-(4-aminophenoxy) phenyl)]sulfone | MDI | 5.06 | 0.004 |
| Specimen 7 | 1,8-diaminooctane | 1,3-bis (isocyanatomethyl) cyclohexane | 3.38 | - |
| Specimen 8 | N,N'-dimethyl-1,6 -diaminohexane | 1,3-bis (isocyanatomethyl) cyclohexane | 3.67 | - |
| Specimen 9 | 1,3-bis(aminomethyl) cycloxane (cis-, trans-mixture) | 1,3-bis (isocyanatomethyl) cyclohexane | 3.67 | - |
| Specimen 10 | 1,3-bis(aminomethyl) cycloxane (cis-, trans-mixture) | m-xylylene diisocyanate | 3.97 | - |
| Specimen 11 | 1,3-bis(aminomethyl) cycloxane (cis-, trans-mixture) | 1,4-phenylendiisocyanate | 4.53 | - |
| Specimen 12 | 1,12-diaminododecane | MDI | 3.78 | - |
| Specimen 13 | 4,4'-methylenbis (cyclohexylamine) (isomeric mixture) | MDI | 3.78 | - |
| Specimen 14 | 4,4'-methylenbis (cyclohexylamine) (isomeric mixture) | 1,4-phenylendiisocyanate | 4.21 | - |

As apparent from the results shown in Table 1, in each of the laminated films of Specimens 1 to 3 in which the vapor-deposited polymer film is formed by the deposition polymerization of the aromatic diamine and the aromatic diisocyanate each having a structure in which two benzene rings are linked via a linking group, the relative dielectric constant of the vapor-deposited polymer film is within a range of 4.68 to 5.08 and the deposition rate is within a range of 0.214 to 0.500 µm/min. Compared with this, in the laminated film of Specimen 4 in which the vapor-deposited polymer film is formed by the deposition polymerization of the combination of the diamine and the diisocyanate in which one of them has a structure in which two benzene rings are directly linked (here, diamine), the vapor-deposited polymer film has the relative dielectric constant of 4.27, which is smaller than the relative dielectric constant of the vapor-deposited polymer film formed in each of the laminated films of Specimens 1 to 3.

In each of the laminated films of Specimens 5 and 6 in which the vapor-deposited polymer film is made of the combination of the diamine and diisocyanate, but one of them (here, diamine) has a structure including three or more benzene rings, the deposition rate is within a range of 0.004 to 0.035 pm/min, which is smaller than the deposition rate of the vapor-deposited polymer film formed in each of the laminated films of Specimens 1 to 3.

Further, in each of the laminated films of Specimens 7 to 14 in which the vapor-deposited polymer film is made of the combination of the diamine and diisocyanate, but at least one of the diamine and the diisocyanate is not aromatic, the relative dielectric constant of the vapor-deposited polymer film is 4.53 or less, which is smaller than the relative dielectric constant of the vapor-deposited polymer film formed in each of the laminated films of Specimens 1 to 3.

From the above results, it can be clearly recognized that the relative dielectric constant is sufficiently improved and the deposition rate is advantageously improved in the vapor-deposited polymer film formed by the deposition polymerization of the aromatic diamine and the aromatic diisocyanate having the structure according to the present invention.

Second, the following experiment was conducted to examine the effect of the composition ratio of the aromatic diisocyanate vapor and the aromatic diamine vapor on the dielectric constant of the vapor-deposited polymer film in the deposition polymerization of the aromatic diisocyanate and the aromatic diamine each having the structure according to the present invention.

Initially, each of commercially available MDI and MDA was provided in a predetermined amount as the aromatic diisocyanate and the aromatic diamine. Further, seven commercially available metallized films in each of which an aluminum vapor-deposited film is formed on one surface of a polypropylene film were provided. Further, as a device for forming a vapor-deposited polymer film, the same device as used in the formation of the vapor-deposited polymer film of Specimen 1 was provided.

Then, as shown in Table 2, a vapor-deposited polymer film was formed on an aluminum vapor-deposited film of each of seven metallized films under the same condition as the formation of the vapor-deposited polymer film of Specimen 1 with various MDI and MDA vapor pressures, thereby obtaining seven laminated films. The seven laminated films are referred to as Specimens 15 to 21.

**Table 2**

| | Vapor Pressure (Pa) | | Relative Dielectric Constant |
|---|---|---|---|
| | MDA | MDI | |
| Specimen 15 | 2 | 2 | 5.08 |
| Specimen 16 | 3 | 2 | 5.21 |
| Specimen 17 | 4 | 2 | 5.75 |
| Specimen 18 | 5 | 2 | - |
| Specimen 19 | 2 | 3 | 4.99 |
| Specimen 20 | 2 | 4 | 4.90 |
| Specimen 21 | 2 | 6 | 4.93 |

As apparent from the results shown in Table 2, the vapor-deposited polymer film of Specimen 15 that was formed by the deposition polymerization in which the MDI vapor pressure and the MDA vapor pressure is the same, i.e., in which the composition ratio (based on weight) of the aromatic diisocyanate and the aromatic diamine is 1:1, has the relative dielectric constant of 5.08. Compared to this, the vapor-deposited polymer film of Specimen 17 that was formed by the deposition polymerization in which the MDI vapor pressure is 2 Pa and the MDA vapor pressure is 4 Pa, i.e., the composition ratio (based on weight) of the aromatic diisocyanate and the aromatic diamine is 1:2 which is the aromatic diamine-rich atmosphere, has the relative dielectric constant of 5.75. Further, each of the vapor-deposited polymer films of Specimens 19 to 21 that was formed by the deposition polymerization in which the MDA vapor pressure is smaller than the MDI vapor pressure, i.e., under the aromatic diisocyanate-rich atmosphere, has the relative dielectric constant smaller than that of the vapor-deposited polymer film of Specimen 15.

As apparent from the above, the relative dielectric constant of the vapor-deposited polymer film can be effectively improved by the formation of the vapor-deposited polymer film by the deposition polymerization under the aromatic diamine-rich atmosphere. Further, the vapor-deposited polymer film was not formed in a state where the MDA vapor pressure was 5 Pa and the MDI vapor pressure was 2 Pa, because the aromatic diamine vapor was too much.

Thirdly, the following experiment was conducted to examine the effect of the post-treatment to the vapor-deposited film that was formed by the deposition polymerization of the aromatic diisocyanate and the aromatic diamine on the relative dielectric constant of the vapor-deposited polymer film.

As the aromatic diisocyanate and the aromatic diamine, commercially available MDI and MDA were each provided in a predetermined amount. Further, there were provided four commercially available metallized films including a polypropylene film and an aluminum film on a surface of the polypropylene film. Further, as a device for forming a vapor-deposited polymer film, the same device as the one used in the production of the vapor-deposited polymer film of Specimen 1 was provided.

By the same process as in the production of the vapor-deposited polymer film of Specimen 1, the vapor-deposited polymer film was formed on each of the aluminum vapor-deposited films of the four metallized films, thereby obtaining four laminated films.

Then, plasma of argon gas was applied to the vapor-deposited polymer film formed on one of the four laminated films to perform the plasma treatment. The laminated film including the vapor-deposited polymer film that was subjected to the plasma treatment is referred to as Specimen 22. Further, the heat treatment was performed at 160°C for 10 minutes on the vapor-deposited polymer film formed on another one of the four laminated films. The laminated film including the vapor-deposited polymer film that was subjected to the heat treatment is referred to as Specimen 23. Further, on the vapor-deposited polymer film formed on further another one of the four laminated films, the heat treatment and the plasma treatment was performed were concurrently performed by heating at 160°C for 10 minutes and by applying the plasma of argon gas. The laminated film including the vapor-deposited polymer film that was subjected to the heat treatment and the plasma treatment is referred to as Specimen 24. In addition, the laminated film including the vapor-deposited polymer film that was not subjected to a post-treatment is referred to as Specimen 25. The relative dielectric constant of the vapor-deposited polymer film in each of the laminated films of Specimens 22 to 25 was measured by a conventional method. The results thereof are shown in Table 3.

**Table 3**

| | Post-Treatment | Relative Dielectric Constant |
|---|---|---|
| Specimen 22 | Plasma Treatment | 5.16 |
| Specimen 23 | Heat Treatment | 4.77 |
| Specimen 24 | Plasma Treatment+ Heat Treatment | 5.26 |
| Specimen 25 | N/A | 4.75 |

As apparent from the results shown in Table 3, the relative dielectric constant of each of the vapor-deposited polymer films of Specimens 22 to 24 that was subjected to at least one of the heat treatment and the plasma treatment is higher than that of the vapor-deposited polymer film of Specimen 25 that was not subjected to a post-treatment. Accordingly, it can be clearly recognized that the relative dielectric constant of the vapor-deposited polymer film can be improved by the post-treatment such as the heat treatment and the plasma treatment.

While the specific embodiment of the present invention has been described in detail, for illustrative purpose only, it is to be understood that the present invention is not limited to the details of the illustrated embodiments.

For example, the order of the vapor-deposited polymer film 16 and the metal deposition films 14a, 14b on the resin film 12 is not particularly limited to the order described above. The metal deposition film 14a, the vapor-deposited polymer film 16, and the metal deposition film 14b may be formed on the resin film 12 in the order of the description.

Further, the number of the vapor-deposited polymer films 16 may be two ore more. Specifically, the vapor-deposited polymer films 16 and the metal deposition films 14b may be alternately formed on one or both surfaces of the resin film 12. Alternatively, the vapor-deposited polymer film 16 may be formed on each surface of the resin film 12 with the respective metal deposition films 14a, 14b therebetween. Alternatively, the vapor-deposited polymer film 16 may be formed on one surface of the resin film 12 with the metal deposition film 14a therebetween and the vapor-deposited polymer films 16 and the metal deposition films 14b may be each alternately formed on the other surface of the resin film 12. In the case where the vapor-deposited polymer films 16 are formed, it is to be understood that the vapor-deposited polymer films 16 may be formed of the same kind of resin film or at least one of the vapor-deposited polymer films 16 may be formed of a different kind of resin film.

The dielectric film may only include the vapor-deposited polymer film 16 without the resin film 12. In such a case, a plurality of laminated bodies that includes one vapor-deposited polymer film 16 and one metal deposition film 14a on one surface of the vapor-deposited polymer film 16 are stacked with each other such that the vapor-deposited polymer film 16 and the metal deposition film 14a are alternately positioned. The film capacitor element may be constituted by a laminated body including one vapor-deposited polymer film 16 and metal deposition films 14a and 14b formed on respective surfaces of the vapor-deposited polymer film 16. Further, the film capacitor element may be constituted by a laminated body including a plurality of vapor-deposited polymer films 16 and a plurality of metal deposition films 14a each alternately positioned.

The film capacitor element including the dielectric film constituted by only the vapor-deposited polymer film 16 is produced, for example, with a production apparatus that has the same structure as the production apparatus 18 shown in Fig. 2 except that the feeding roller 32 and the take up roller 34 are not provided and the device for forming a metal deposition film 44 and the device for forming a vapor-deposited polymer film 46 are provided in the vacuum chamber 20 in the number corresponding to the number of the layers of the metal deposition films 14a (14b) and the vapor-deposited polymer films 16. In such a production apparatus, the device for forming a metal deposition film 44 and the device for forming a vapor-deposited polymer film 46 are arranged around the can roller 38 alternately in the circumferential direction thereof.

Further, although only two monomers were used in Specimens described herein, more than two monomers may be used to form a vapor-deposited polymer film, depending on a kind of the vapor-deposited polymer film.

Although further details will not be described herein, it is to be understood that the present invention may be embodied with various other changes and modifications which may occur to those skilled in the art, without departing from the scope of the invention as set forth with the appended claims.

## Claims

1. A film capacitor element (10) comprising a laminated body including at least one dielectric film (12, 16) and at least one metal deposition film (14a, 14b),
wherein at least one of the at least one dielectric film is a vapor-deposited polymer film (16) formed by a deposition polymerization of a plurality of monomers, the plurality of monomers each having a structure in which two benzene rings are linked via a linking group,
**characterized in that**
each of the plurality of monomers has a functional group positioned at a para position with respect to a linking group, and the plurality of monomers are polymerized via the functional group.

2. The film capacitor element according to claim 1, wherein dipoles in the at least one vapor-deposited polymer film are oriented by being subjected to at least one of a heat treatment, an ultraviolet treatment, an electron-beam treatment, a magnetic treatment, an electric field treatment, and a plasma treatment.

3. The film capacitor element according to claim 1 or claim 2, wherein the at least one vapor-deposited polymer film is a polyurea resin film.

4. The film capacitor element according to any one of claims 1 to 3, wherein the plurality of monomers include aromatic diamine and aromatic diisocyanate.

5. The film capacitor element according to claim 4, wherein the at least one vapor-deposited polymer film is obtained by polymerizing the aromatic diamine and the aromatic diisocyanate under an aromatic diamine-rich atmosphere in which an aromatic diamine vapor pressure is higher than an aromatic diisocyanate vapor pressure.

6. The film capacitor element according to claim 4 or 5, wherein the aromatic diamine is 4,4'-diamino diphenyl methane and the aromatic diisocyanate is 4,4'-diphenylmethane diisocyanate.

7. A film capacitor comprising the film capacitor element (10) according to any one of claims 1 to 6.

8. A method of producing a film capacitor element (10) comprising a laminated body including at least one dielectric film (12, 16) and at least one metal deposition film (14a, 14b), comprising the steps of:
obtaining the laminated body such that the at least one metal deposition film and the at least one dielectric film are each positioned alternately; and
obtaining a film capacitor element (10) using the laminated body,
wherein at least one of the at least one dielectric film is a vapor-deposited polymer film (16) formed by a deposition polymerization of a plurality of monomers, the plurality of monomers each having a structure in which two benzene rings are linked via a linking group,
**characterized in that**
each of the plurality of monomers has a functional group positioned at a para position with respect to a linking group, and the plurality of monomers are polymerized via the functional group.

9. The method of producing a film capacitor element according to claim 8, further comprising the step of performing at least one of a heat treatment, an ultraviolet treatment, an electron-beam treatment, a magnetic treatment, an electric field treatment, and a plasma treatment to the at least one vapor-deposited polymer film.

10. The method of producing a film capacitor element according to claim 8 or claim 9, wherein the plurality of monomers include aromatic diamine and aromatic diisocyanate, and the at least one vapor-deposited polymer film formed of a polyurea resin film is formed by the deposition polymerization of the aromatic diamine and the aromatic diisocyanate.

11. The method of producing a film capacitor element according to claim 10, wherein the at least one vapor-deposited polymer film is formed by polymerizing the aromatic diamine and the aromatic diisocyanate under an aromatic diamine-rich atmosphere in which an aromatic diamine vapor pressure is higher than an aromatic diisocyanate vapor pressure.

12. The method of producing a film capacitor element according to claim 10 or 11, wherein the aromatic diamine is 4,4'-diamino diphenyl methane and the aromatic diisocyanate is 4,4'-diphenylmethane diisocyanate.

## Patentansprüche

1. Schichtkondensatorelement (10), das einen laminierten Körper, einschließlich zumindest einer dielektrischen Schicht (12, 16) und zumindest einer Metallabscheidungsschicht (14a, 14b), umfasst,
worin zumindest eine aus der zumindest einen dielektrischen Schicht eine dampfabgeschiedene Polymerschicht (16) ist, die durch eine Abscheidungspolymerisation aus einer Vielzahl von Monomeren gebildet wurde, wobei die Vielzahl von Monomeren jeweils eine Struktur aufweist, in der zwei Benzolringe über eine Linkergruppe verbunden sind,
**dadurch gekennzeichnet, dass**
jedes aus der Vielzahl von Monomeren eine funktionelle Gruppe aufweist, die an einer para-Position in Bezug auf eine Linkergruppe positioniert ist, und die Vielzahl von Monomeren über die funktionelle Gruppe polymerisiert wird.

2. Schichtkondensatorelement nach Anspruch 1, worin Dipole in der zumindest einen dampfabgeschiedenen Polymerschicht durch Aussetzen gegenüber zumindest einer aus einer Wärmebehandlung, einer UV-Behandlung, einer Elektronenstrahlbehandlung, einer Magnetbehandlung, einer Elektrofeldbehandlung und einer Plasmabehandlung ausgerichtet werden.

3. Schichtkondensatorelement nach Anspruch 1 oder Anspruch 2, worin die zumindest eine dampfabgeschiedene Polymerschicht eine Polyharnstoffharzschicht ist.

4. Schichtkondensatorelement nach einem der Ansprüche 1 bis 3, worin die Vielzahl von Monomeren aromatisches Diamin und aromatisches Diisocyanat umfasst.

5. Schichtkondensatorelement nach Anspruch 4, worin die zumindest eine dampfabgeschiedene Polymerschicht durch Polymerisieren des aromatischen Diamins und des aromatischen Diisocyanats unter einer aromatischen diaminreichen Atmosphäre erhalten wird, in der ein Dampfdruck des aromatischen Diamins höher ist als ein Dampfdruck des aromatischen Diisocyanats.

6. Schichtkondensatorelement nach Anspruch 4 oder 5, worin das aromatische Diamin 4,4'-Diaminodiphenylmethan ist und das aromatische Diisocyanat 4,4'-Diphenylmethandiisocyanat ist.

7. Schichtkondensator, der das Schichtkondensatorelement (10) nach einem der Ansprüche 1 bis 6 umfasst.

8. Verfahren zur Herstellung eines Schichtkondensatorelements (10), das einen laminierten Körper, einschließlich zumindest einer dielektrischen Schicht (12, 16) und zumindest einer Metallabscheidungsschicht (14a, 14b), umfasst, welches die folgenden Schritte umfasst:
Erhalten des laminierten Körpers, so dass die zumindest eine Metallabscheidungsschicht und die zumindest eine dielektrische Schicht jeweils abwechselnd angeordnet sind; und
Erhalten eines Schichtkondensatorelements (10) unter Verwendung des laminierten Körpers,
worin zumindest eine aus der zumindest einen dielektrischen Schicht eine dampfabgeschiedene Polymerschicht (16) ist, die durch Abscheidungspolymerisation von einer Vielzahl von Monomeren gebildet wurde, wobei die Vielzahl von Monomeren jeweils eine Struktur aufweist, in der zwei Benzolringe über eine Linkergruppe verbunden sind,
**dadurch gekennzeichnet, dass**
jedes aus der Vielzahl von Monomeren eine funktionelle Gruppe aufweist, die in Bezug auf eine Linkergruppe an einer para-Position positioniert ist, und die Vielzahl von Monomeren über die funktionelle Gruppe polymerisiert wird.

9. Verfahren zur Herstellung eines Schichtkondensatorelements nach Anspruch 8, das ferner den Schritt des Durchführens zumindest einer aus einer Wärmebehandlung, einer UV-Behandlung, einer Elektronenstrahlbehandlung, einer Magnetbehandlung, einer Elektrofeldbehandlung und einer Plasmabehandlung der zumindest einen dampfabgeschiedenen Polymerschicht umfasst.

10. Verfahren zur Herstellung eines Schichtkondensatorelements nach Anspruch 8 oder Anspruch 9, worin die Vielzahl von Monomeren aromatisches Diamin und aromatisches Diisocyanat umfassen und die zumindest eine dampfabgeschiedene Polymerschicht aus einem Polyharnstoffharzfilm durch die Abscheidungspolymerisation des aromatischen Diamins und des aromatischen Diisocyanats gebildet wird.

11. Verfahren zur Herstellung eines Schichtkondensatorelements nach Anspruch 10, worin die zumindest eine dampfabgeschiedene Polymerschicht durch Polymerisieren des aromatischen Diamins und des aromatischen Diisocyanats unter einer aromatischen diaminreichen Atmosphäre gebildet wird, in der der Dampfdruck des aromatischen Diamins höher ist als ein Dampfdruck des aromatischen Diisocyanats.

12. Verfahren zur Herstellung eines Schichtkondensatorelements nach Anspruch 10 oder 11, worin das aromatische Diamin 4,4'-Diaminodiphenylmethan ist und das aromatische Diisocyanat 4,4'-Diphenylmethandiisocyanat ist.

## Revendications

1. Elément de condensateur à film (10) comprenant un corps stratifié comprenant au moins un film diélectrique (12, 16) et au moins un film de déposition de métal (14a, 14b),
dans lequel au moins l'un de l'au moins un film diélectrique est un film polymère déposé en phase vapeur (16) formé par une polymérisation par déposition d'une pluralité de monomères, chacun parmi la pluralité de monomères ayant une structure dans laquelle deux cycles benzène sont liés via un groupe de liaison,
**caractérisé en ce que**
chacun parmi la pluralité de monomères a un groupe fonctionnel positionné en position para par rapport à un groupe de liaison, et la pluralité de monomères est polymérisée via le groupe fonctionnel.

2. Elément de condensateur à film selon la revendication 1, dans lequel des dipôles dans l'au moins un film polymère déposé en phase vapeur sont orientés en étant soumis à au moins l'un parmi un traitement à la chaleur, un traitement aux ultraviolets, un traitement par un faisceau d'électrons, un traitement magnétique, un traitement par un champ électrique, et un traitement au plasma.

3. Elément de condensateur à film selon la revendication 1 ou la revendication 2, dans lequel l'au moins un film polymère déposé en phase vapeur est un film en résine de polyurée.

4. Elément de condensateur à film selon l'une quelconque des revendications 1 à 3, dans lequel la pluralité de monomères comprend une diamine aromatique et un diisocyanate aromatique.

5. Elément de condensateur à film selon la revendication 4, dans lequel l'au moins un film polymère déposé en phase vapeur est obtenu par polymérisation de la diamine aromatique et du diisocyanate aromatique dans une atmosphère riche en diamine aromatique dans laquelle la pression de vapeur de la diamine aromatique est supérieure à la pression de vapeur du diisocyanate aromatique.

6. Elément de condensateur à film selon la revendication 4 ou 5, dans lequel la diamine aromatique est le 4,4'-diaminodiphénylméthane et le diisocyanate aromatique est le diisocyanate de 4,4'-diphénylméthane.

7. Condensateur à film comprenant l'élément de condensateur à film (10) de l'une quelconque des revendications 1 à 6.

8. Procédé de production d'un élément de condensateur à film (10) comprenant un corps stratifié comprenant au moins un film diélectrique (12, 16) et au moins un film de déposition de métal (14a, 14b), comprenant les étapes consistant à :
obtenir le corps stratifié de façon que chacun parmi l'au moins un film de déposition de métal et l'au moins un film diélectrique soient positionnés en alternance ; et
obtenir un élément de condensateur à film (10) utilisant le corps stratifié,
dans lequel l'au moins un de l'au moins un film diélectrique est un film polymère déposé en phase vapeur (16) formé par une polymérisation par déposition d'une pluralité de monomères, chacun parmi la pluralité de monomères ayant une structure dans laquelle deux cycles benzène sont liés via un groupe de liaison,
**caractérisé en ce que**
chacun parmi la pluralité de monomères a un groupe fonctionnel positionné en position para par rapport à un groupe de liaison, et la pluralité de monomères est polymérisée via le groupe fonctionnel.

9. Procédé de production d'un élément de condensateur à film selon la revendication 8, comprenant en outre l'étape de réalisation d'au moins l'un parmi un traitement à la chaleur, un traitement aux ultraviolets, un traitement par un faisceau d'électrons, un traitement magnétique, un traitement par un champ électrique, et un traitement au plasma sur l'au moins un film polymère déposé en phase vapeur.

10. Procédé de production d'un élément de condensateur à film selon la revendication 8 ou la revendication 9, dans lequel la pluralité de monomères comprend une diamine aromatique et un diisocyanate aromatique, et l'au moins un film polymère déposé en phase vapeur formé d'un film en résine de polyurée est formé par polymérisation par déposition de la diamine aromatique et du diisocyanate aromatique.

11. Procédé de production d'un élément de condensateur à film selon la revendication 10, dans lequel l'au moins un film polymère déposé en phase vapeur est formé par polymérisation de la diamine aromatique et du diisocyanate aromatique dans une atmosphère riche en diamine aromatique dans laquelle la pression de vapeur de la diamine aromatique est supérieure à la pression de vapeur du diisocyanate aromatique.

12. Procédé de production d'un élément de condensateur à film selon la revendication 10 ou 11, dans lequel la diamine aromatique est le 4,4'-diaminodiphénylméthane et le diisocyanate aromatique est le diisocyanate de 4,4'-diphénylméthane.
